# EUROPEAN PATENT APPLICATION

(11) **EP 4 709 130 A2**
(43) Date of publication of application: **11.03.2026**
(21) Application number: 25200562.4
(22) Date of filing: 05.09.2025
(51) Int. Cl.: H10P 72/10

(54) **MASKING DEVICE FOR PACKAGING TRAY**

(30) Priority: 06.09.2024 KR 20240121264
(71) Applicant: S.S.P. Inc., Incheon Incheon 21999 (KR)
(72) Inventor: Ki, Young-sik, 21324 Incheon (KR)
(74) Representative: Petraz, Gilberto Luigi

(57) **Abstract**

Proposed is a masking device for a packaging tray, which enables laser processing of a chip without thermal damage to a packaging tray by installing the masking device on the packaging tray while the chip placed on the packaging tray is vertically raised by a heating block. The masking device may include a mask part installed in a grid shape above a packaging tray in which a mounting part on which a chip is mounted is provided to form a number of rows and columns to protect the packaging tray from a heat source.

## Description

### CROSS REFERENCE TO RELATED APPLICATION

The present application claims priority to Korean Patent Application No. 10-2024-0121264, filed September 6, 2024, the entire contents of which is incorporated herein for all purposes by this reference.

### BACKGROUND

### Technical Field

The present disclosure relates to a masking device for a packaging tray and, more particularly, to a masking device for a packaging tray, the device enabling laser processing of a chip without thermal damage to a packaging tray by installing the masking device on the packaging tray while the chip placed on the packaging tray is vertically raised by a heating block.

### Description of the Related Art

A packaging tray is a tray that meets standardized specifications for storing and transporting multiple semiconductor packages.

In general, packaging trays can be used to load semiconductor packages onto process trays for loading into a preprocessing process, to unload semiconductor packages on process trays after completion of a process, or to accommodate semiconductor packages for an inspection process such as a vision test.

In addition, in order to process semiconductor packages on which shielding films have been formed via sputtering deposition, a post-processing process is also required to separate the semiconductor packages with the shielding films from process trays and unload the separated semiconductor packages from the process trays to packaging trays.

By the above-described post-processing process, the semiconductor packages on the process trays on which the shielding films are formed are separated from the process trays by vacuum suction using a picker for pick and place, and the separated semiconductor packages need to be individually unloaded from the process trays to the packaging trays using the picker.

As described above, loading of semiconductor packages to form shielding films and unloading of semiconductor packages with shielding films formed are individually performed for the semiconductor packages in the process trays or packaging trays. Thus, it takes a lot of time to load a large number of semiconductor packages accommodated in one packaging tray into a process tray or to unload a large number of semiconductor packages on a process tray into a packaging tray, which reduces productivity.

In particular, as the size of a semiconductor package decreases, the number of semiconductor packages accommodated in a packaging tray and process tray increases, and thus the time required to load or unload the semiconductor packages into the process tray before or after sputtering deposition increases, which contributes to a decrease in productivity.

Moreover, because loading and unloading of a semiconductor package between the packaging tray and the process tray may cause damage to the semiconductor package, there is a need for a method that enables a process such as laser processing to be performed on a semiconductor package while the semiconductor package is contained in the packaging tray without unloading the semiconductor package from a packaging tray to a separate process tray.

### Document of Related Art

(Patent Document 1) Korean Patent No. 10-0874610, (December 11, 2008)

### SUMMARY

Accordingly, the present disclosure has been made keeping in mind the above problems occurring in the related art, and the present disclosure is intended to provide a masking device for a packaging tray, the device enabling laser processing of a chip without thermal damage to a packaging tray by installing the masking device on the packaging tray while the chip placed on the packaging tray is vertically raised by a heating block.

In order to achieve the above objective, according to an aspect of the present disclosure, there is provided a masking device for a packaging tray, the device including a mask part installed in a grid shape above a packaging tray in which a mounting part on which a chip is mounted is provided to form a number of rows and columns to protect the packaging tray from a heat source.

In addition, the mask part may include: a first mask installed transversely on the packaging tray; and a second mask installed longitudinally on the packaging tray so as to intersect with the first mask.

In addition, the second mask may be installed to penetrate or overlap the first mask.

In addition, the first mask may be formed in a bar shape and may be installed between vertical members of a heating block that enter the mounting part of the packaging tray.

In addition, the first mask may have a protrusion formed.

In addition, the second mask may be made up of a plurality of bars, and first ends of the bars are formed integrally by a connection part.

In addition, the mask part may include a third mask and a fourth mask that are stacked vertically, wherein the third mask and the fourth mask may be each provided with a plurality of rows and columns of through holes shaped and sized to allow a chip mounted on a vertical member of a heating block to pass through are arranged in a grid shape.

In addition, the third mask and the fourth mask may be moved in parallel in opposite directions so that first sides of the through holes of one mask in a moving direction may be covered by the other mask, thereby covering the packaging tray that is exposed to a periphery of the chip mounted on the vertical member.

According to the present disclosure, by installing a masking device on a packaging tray while a chip is vertically raised by a heating block, laser processing of the chip is possible without thermal damage to the packaging tray.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a perspective view showing a state in which a masking device for a packaging tray according to the present disclosure is installed on a packaging tray;
FIG. 2 is a perspective view showing a separated state of a masking device for a packaging tray according to the present disclosure;
FIG. 3 is a view showing a first mask of a masking device for a packaging tray according to the present disclosure;
FIG. 4 is a view showing a second mask of a masking device for a packaging tray according to the present disclosure;
FIG. 5 is a cross-sectional view taken along line A-A' of FIG. 1;
FIG. 6 is a partially enlarged view of FIG. 5;
FIG. 7 is a plan view showing a state in which a masking device for a packaging tray according to the present disclosure is installed;
FIGS. 8 to 12B are views showing a process of installing a masking device for a packaging tray according to the present disclosure and performing laser processing;
FIG. 13 is a view showing another embodiment of a masking device for a packaging tray according to the present disclosure; and
FIGS. 14A to 14C are views showing the installation state of a mask part of FIG. 13.

### DETAILED DESCRIPTION

Embodiments of this disclosure are exemplified for the purpose of explaining the technical idea of this disclosure. The scope of rights under this disclosure is not limited to the embodiments presented below or the specific descriptions of the embodiments.

All technical and scientific terms used in this disclosure, unless otherwise defined, have the meaning commonly understood by a person of ordinary skill in the art to which this disclosure belongs. All terms used in this disclosure have been selected for the purpose of more clearly describing this disclosure and have not been selected to limit the scope of rights under this disclosure.

Expressions such as "including", "comprising", "having", and the like used in this disclosure should be understood as open-ended terms that imply the possibility of including other embodiments, unless otherwise stated in the phrase or sentence in which the expression is included.

The singular forms described in this disclosure may include plural meanings unless otherwise stated, and the same applies to the singular forms described in the claims.

Hereinafter, a preferred embodiment of a masking device for a packaging tray according to the present disclosure will be described in detail with reference to the attached drawings.

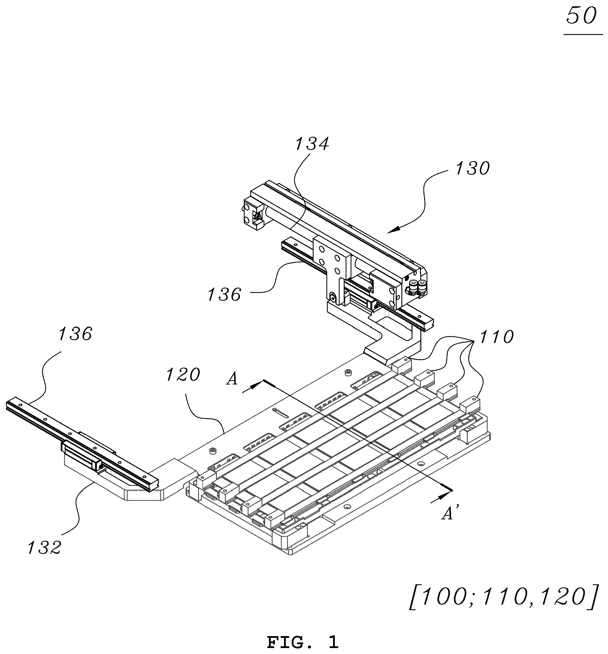

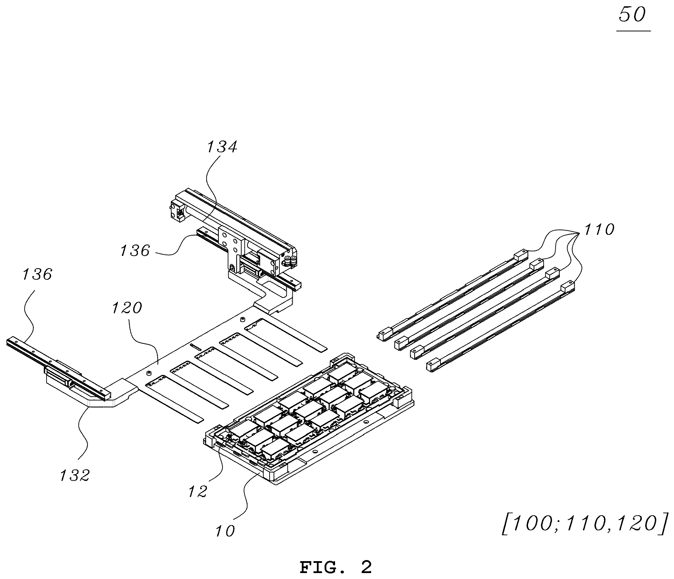

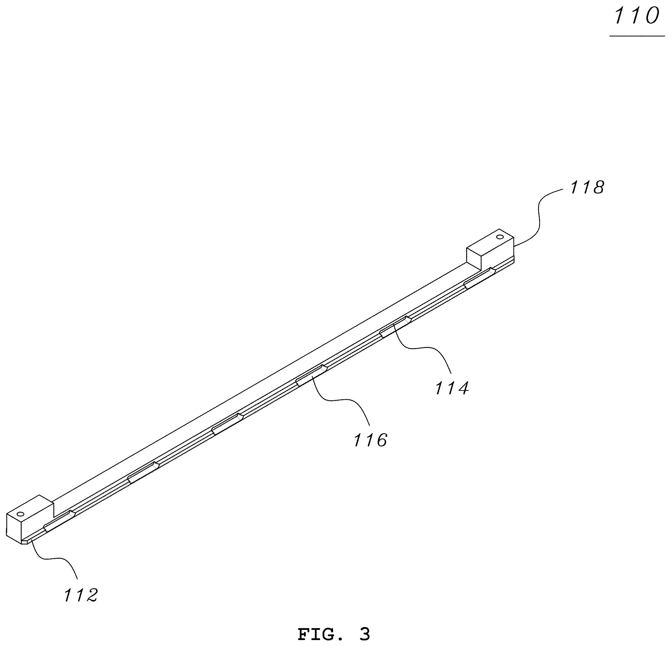

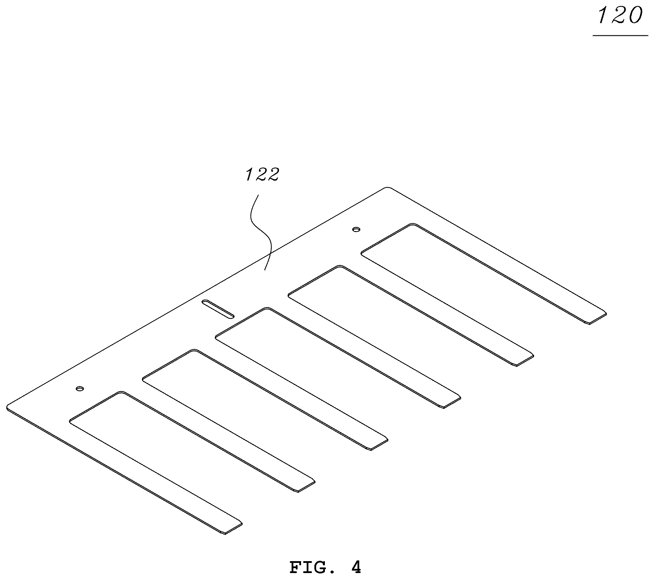

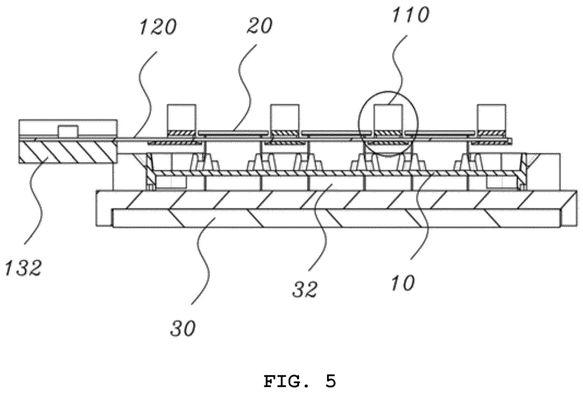

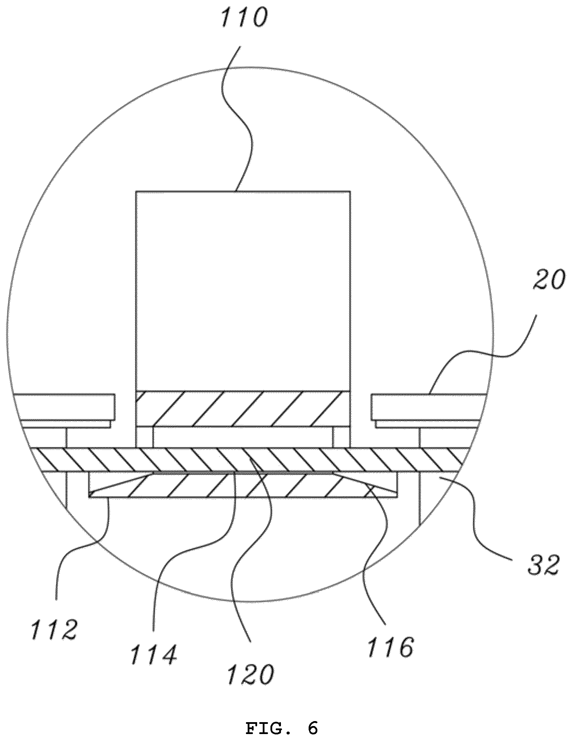

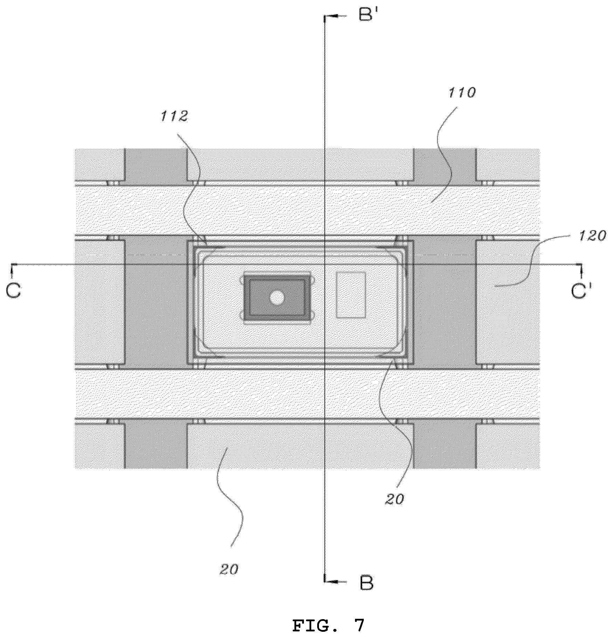

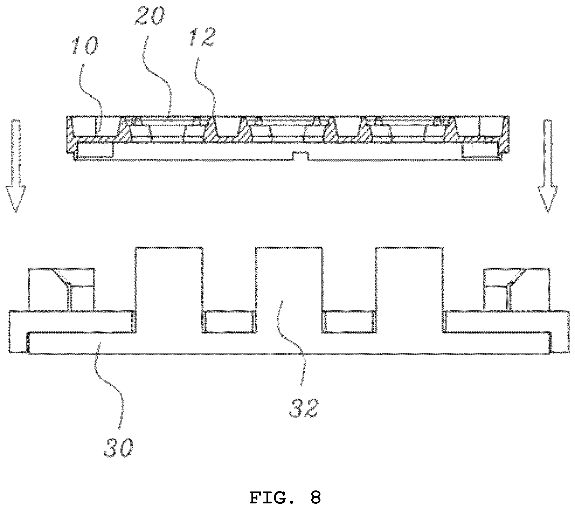

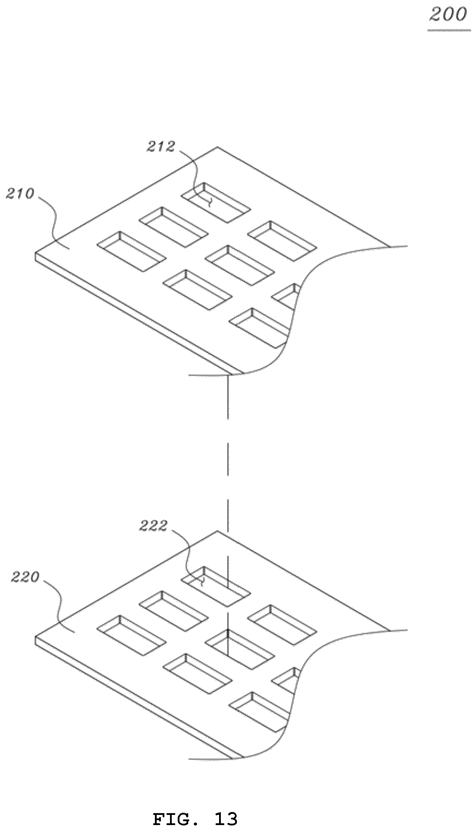

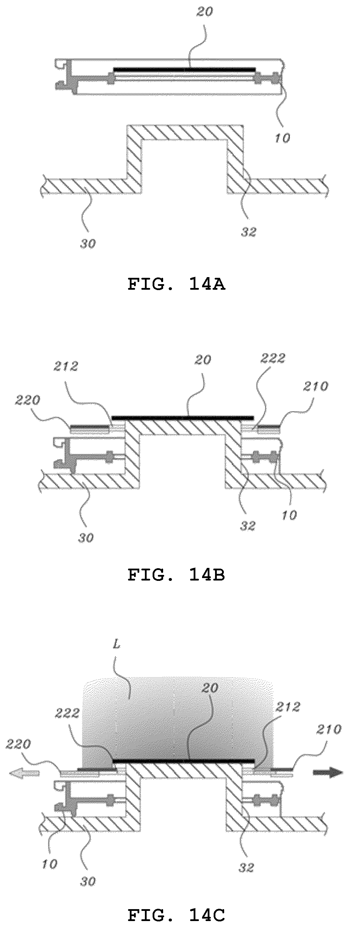

FIG. 1 is a perspective view showing a state in which a masking device for a packaging tray according to the present disclosure is installed on a packaging tray; FIG. 2 is a perspective view showing a separated state of a masking device for a packaging tray according to the present disclosure; FIG. 3 is a view showing a first mask of a masking device for a packaging tray according to the present disclosure; FIG. 4 is a view showing a second mask of a masking device for a packaging tray according to the present disclosure; FIG. 5 is a cross-sectional view taken along line A-A' of FIG. 1; FIG. 6 is a partially enlarged view of FIG. 5; FIG. 7 is a plan view showing a state in which a masking device for a packaging tray according to the present disclosure is installed; FIGS. 8 to 12B are views showing a process of installing a masking device for a packaging tray according to the present disclosure and performing laser processing; FIG. 13 is a view showing another embodiment of a masking device for a packaging tray according to the present disclosure; and FIGS. 14A to 14C are views showing the installation state of a mask part of FIG. 13.

The present disclosure relates to a masking device 50 for a packaging tray, the device enabling laser processing of a chip without thermal damage to a packaging tray by installing the masking device on the packaging tray while the chip placed on the packaging tray is vertically raised by a heating block. As shown in FIGS. 1 to 7, the masking device 50 of the present disclosure may include a mask part 100 installed in a grid shape above a packaging tray 10 in which a mounting part 12 on which a chip 20 is mounted is provided to form a number of rows and columns to protect the packaging tray 10 from a heat source.

The chip 20 mounted on the mounting part 12 of the packaging tray 10 is placed on the top of a heating block 30 when a vertical member 32 of the heating block 30 rises from the bottom to the top through the mounting part 12.

In this case, the chip 20 is formed to have an area larger than the upper area of the vertical member 32 so as to protrude outward from the upper perimeter of the vertical member 32.

At this time, the mask part 100 is installed in a separation space between the packaging tray 10 and the chip 20 so that the packaging tray 10 is not exposed based on a flat surface, thereby protecting the packaging tray 10 from a heat source during laser processing of the chip 20.

To be specific, the mask part 100 may include: a first mask 110 installed transversely on the packaging tray 10; and a second mask 120 installed longitudinally on the packaging tray 10 so as to intersect with the first mask 110.

At this time, the first mask 110 is formed in a bar shape and is installed between the vertical members 32 of the heating block 30 that enter the mounting part 12 of the packaging tray 10, and a protrusion 112 is provided on each side of the first mask 110 in the width direction.

The protrusion 112 is formed to protrude toward the vertical member 32 when the first mask 110 is installed on the packaging tray 10, and is positioned below the chip 20 mounted on the adjacent vertical member 32.

Meanwhile, the second mask 120 is made up of a plurality of bars, and first ends of individual bars may be formed integrally by a connection part 122.

The second mask 120 is configured such that the width of each bar portion is larger than the gap between the chips 20 mounted on the vertical member 32, and may be installed so as to penetrate the first mask 110 and intersect with each other.

That is, the first mask 110 and the second mask 120 may be installed to intersect with each other as the bar portions of the second mask 120 penetrate through holes 114 formed in the first mask 110 in the width direction.

At this time, since the second mask 120 enters the through holes 114 of the first mask 110 and supports the first mask 110, it is preferable that the second mask 120 be made of a material having a certain level of rigidity or higher so as to stably support the first mask 110.

Due to the above configuration, the first mask 110 and the second mask 120 are combined with each other in a grid shape, and the bar portion of the second mask 120 and the protrusion 112 of the first mask 110 are positioned close to the bottom surface of the chip 20 so as to prevent the packaging tray 10 from being exposed between the chips 20 based on a flat surface as shown in FIG. 7, a laser beam L emitted toward the upper surface of the chip 20 during laser processing of the chip 20 is effectively blocked from reaching the packaging tray 10 by the first mask 110 and the second mask 120, thereby preventing thermal damage to the packaging tray caused by the laser.

The above-described series of processes will be explained with reference to FIGS. 8 to 12.

First, as shown in FIG. 8, the packaging tray 10 with the chip 20 mounted on the mounting part 12 is mounted on the heating block 30.

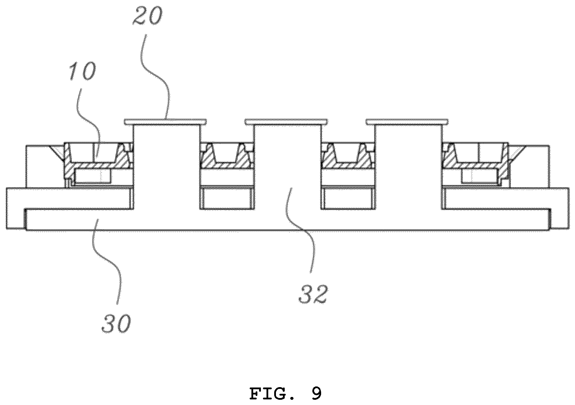

At this time, as shown in FIG. 9, as the vertical member 32 of the heating block 30 enters through the mounting part 12, the chip 20 is vertically raised and separated from the packaging tray 10.

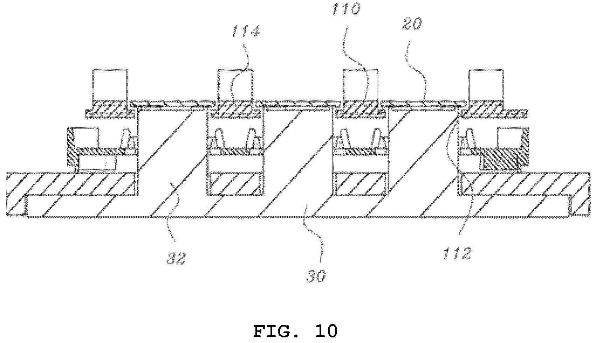

Next, as shown in FIG. 10, the first mask 110 is installed so as to be positioned between the vertical members 32 of the heating block 30.

At this time, the protrusion 112 of the first mask 110 is positioned below the chip 20.

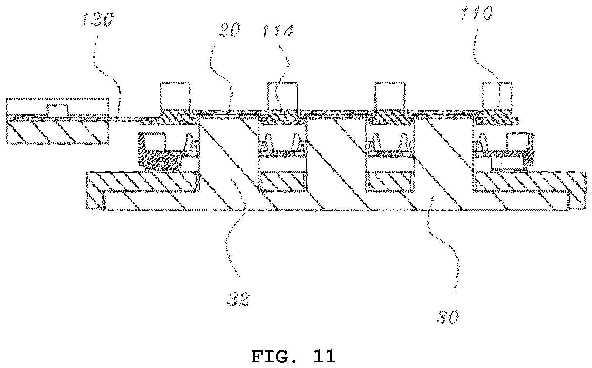

Next, as shown in FIG. 11, the second mask 120 is installed by means of the through holes 114 of the first mask 110 to form a grid with the first mask 110, thereby completing the installation of the mask part 100 of the present disclosure.

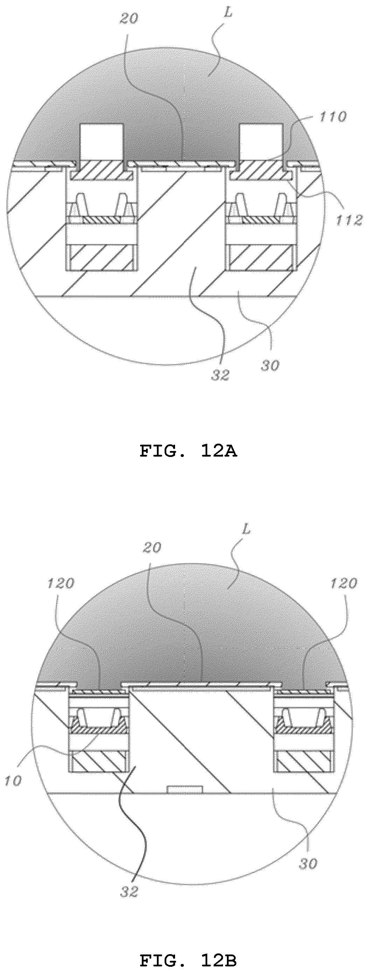

FIG. 12A is the B-B' cross-section of FIG. 7, and FIG. 12B is the C-C' cross-section of FIG. 7. As shown in FIG. 12A, the laser beam L emitted toward the upper surface of the chip 20 during laser processing of the chip 20 is blocked from reaching the packaging tray 10 by the protrusions 112 of the first mark 110, and as shown in FIG. 12B, by blocking the laser beam L from reaching the packaging tray 10 by the second mask 120, thermal damage to the packaging tray 10 caused by the laser (heat source) may be prevented.

Meanwhile, the protrusion 112 of the first mask 110 has an inclined surface 116 provided at each end thereof where the through hole 114 is formed, which has a downward slope toward the outside in the width direction of the first mask 110.

Thus, when the second mask 120 enters the through hole 114 of the first mask 110 by means of the bar portion, the second mask 120 is guided along the inclined surface 116 so as to be easily combined with the first mask 110.

Meanwhile, the second mask 120 may be coupled to or released from the first mask 110 by a moving means 130.

At this time, the moving means 130 includes: a connection body 132 in which the connection part 122 of the second mask 120 is installed; and a linear guide 134 to which the connection body 132 is connected and which moves the connection body 132 forward and backward.

Thus, according to the operation of the linear guide 134, the connection body 132 and the second mask 120 connected thereto move forward and backward to be coupled to or released from the first mask 110.

In this case, a movement prevention guide 136 may be further provided to guide the connection body 132 so that connection body 132 does not shake when the connection body 132 and the second mask 120 connected thereto move.

Meanwhile, although not shown, the bar portion of the second mask 120 may be installed so that the first mask 110 and the second mask 120 intersect each other as the bar portion enters beneath the first mask 110 and supporting the first mask 110 while overlapping with the first mask 110.

At this time, the first mask 110 may have a groove (not shown) formed concavely upward on the bottom thereof with a size corresponding to the width of the bar portion of the second mask 120, so that when the first mask 110 and the second mask 120 are installed crosswise, movement between the first mask 110 and the second mask 120 may be prevented.

Meanwhile, according to another embodiment of the present disclosure, as shown in FIG. 13, a mask part 200 may consist of a third mask 210 and a fourth mask 220 that are stacked vertically. In the third mask 210 and the fourth mask 220, a plurality of rows and columns of through holes 212 and 222 shaped and sized to allow a chip 20 to pass through are arranged in a grid shape corresponding to the position of the mounting part 12 of the packaging tray 10.

Thus, the mask part 200 is installed on the packaging tray 10 in a state where the third mask 210 and the fourth mask 220 are stacked so that the through holes 212 and 222 of the third mask 210 and the fourth mask 220 are aligned to allow the chip 20 to pass through the through holes 212 and 222.

That is, as shown in FIGS. 14A to 14B, the mask part 200 is installed while the chip 20 is mounted on the vertical member 32 of the heating block 30 that has entered through the mounting part 12 of the packaging tray 10.

Next, as shown in FIG. 14C, when the third mask 210 and the fourth mask 220 are moved in parallel in opposite directions, that is, left and right, up and down, or in opposite diagonal directions, first sides of the through holes 212 or 222 of one mask 210 or 220 in the moving direction are covered by the other mask 220 or 210.

As the through holes 212 or 222 of one mask 210 or 220 are covered by the other mask 210 or 220 when the third mask 210 and the fourth mask 220 are moved in parallel, the packaging tray 10 that is exposed to the periphery of the chip 20 mounted on the vertical member 32 is covered, so that the laser beam for processing the chip 20 is effectively blocked from reaching the packaging tray 10 by the mask part 200, thereby preventing thermal damage to the packaging tray 10 caused by the laser.

In conclusion, the masking device 100 for a packaging tray according to the present disclosure as described above has various advantages such as enabling laser processing of a chip without thermal damage to a packaging tray by installing the masking device on the packaging tray while the chip placed on the packaging tray is vertically raised by a heating block.

The above-described embodiments are the most preferred embodiments of the present disclosure, but the present disclosure is not limited to the above-described embodiments, and it is obvious to those skilled in the art that various modifications are possible within a scope that does not depart from the technical spirit of the present disclosure.

## Claims

1. A masking device for a packaging tray, the device comprising:
a mask part installed in a grid shape above a packaging tray in which a mounting part on which a chip is mounted is provided to form a number of rows and columns to protect the packaging tray from a heat source,
wherein the mask part comprises:
a first mask installed transversely on the packaging tray; and
a second mask installed longitudinally on the packaging tray so as to intersect with the first mask,
wherein the second mask is installed to penetrate or overlap the first mask.

2. (Newly Added) The device of claim 1, wherein the first mask is formed in a bar shape and is installed between vertical members of a heating block that enter the mounting part of the packaging tray.

3. The device of claim 1, wherein the first mask has a protrusion formed.

4. (Newly Added) The device of claim 1, wherein the second mask is made up of a plurality of bars, and first ends of the bars are formed integrally by a connection part.

5. A masking device for a packaging tray, the device comprising:
a mask part installed in a grid shape above a packaging tray in which a mounting part on which a chip is mounted is provided to form a number of rows and columns to protect the packaging tray from a heat source,
wherein the mask part comprises a third mask and a fourth mask that are stacked vertically,
wherein the third mask and the fourth mask are each provided with a plurality of rows and columns of through holes shaped and sized to allow a chip mounted on a vertical member of a heating block to pass through are arranged in a grid shape.

6. (Newly Added) The device of claim 5, wherein the third mask and the fourth mask are moved in parallel in opposite directions so that first sides of the through holes of one mask in a moving direction are covered by the other mask, thereby covering the packaging tray that is exposed to a periphery of the chip mounted on the vertical member.
